# EUROPEAN PATENT APPLICATION

(11) **EP 2 278 630 A1**
(43) Date of publication of application: **26.01.2011**
(21) Application number: 09731096.5
(22) Date of filing: 03.04.2009
(51) Int. Cl.: H01L 31/052, G02B 3/00, G02B 3/08, H01L 31/042

(54) **OPTICAL MEMBER FOR LIGHT CONCENTRATION AND CONCENTRATOR PHOTOVOLTAIC MODULE**

(30) Priority: 08.04.2008 JP 2008100478
(71) Applicant: Sharp Kabushiki Kaisha, Osaka-shi, Osaka 545-8522 (JP)
(72) Inventor: YANG, Minju, Osaka-ski OSAKA 545-8522 (JP)
(74) Representative: Müller - Hoffmann & Partner
(86) International application number: PCT/JP2009/056938
(87) International publication number: WO 2009/125722

(57) **Abstract**

A concentrating optical member (50) concentrates sunlight (Lsa) onto a solar cell (10) that generates power using a solar cell element (11) mounted on a receiver substrate (20). The concentrating optical member (50) includes a first optical member (51) having a first refractive index that is disposed on the side on which sunlight (Ls) is incident and a second optical member (52) having a second refractive index that is disposed on the side on which the solar cell element (11) is disposed. The first refractive index and the second refractive index have different values. A concentrating solar power generation module (40) includes the solar cell (10) and the concentrating optical member (50).

## Description

### Technical Field

The present invention relates to a concentrating optical member that can concentrate sunlight onto a solar cell (solar cell element) that can generate power using concentrated sunlight, and a concentrating solar power generation module including such a concentrating optical member and a solar cell.

### Background Art

Non-concentrating, fixed flat plate structures in which a solar power generation module with solar cell elements laid closely together is installed on the roof or the like are most commonly used in solar power generation apparatuses. For such solar power generation apparatuses, a technique has been proposed to reduce the amount of solar cell elements used, which is the most expensive among the members (components) constituting a solar power generation apparatus.

In other words, it has been proposed to concentrate sunlight by using an optical lens, reflecting mirror or the like and direct the concentrated sunlight to a solar cell element with a small area so as to increase the power generation per unit area of the solar cell element, as well as reducing the cost of solar cell elements (in other words, the cost of a solar power generation apparatus).

As element properties, the photovoltaic conversion efficiency of a solar cell element improves as the concentration magnification is increased. However, if the position of the solar cell element remains fixed, most sunlight enters obliquely, failing to make efficient use of the sunlight. In view of this, a sun-tracking concentrating solar power generation apparatus has been proposed that has a high concentration magnification and is configured to track sunlight so as to always receive sunlight face on.

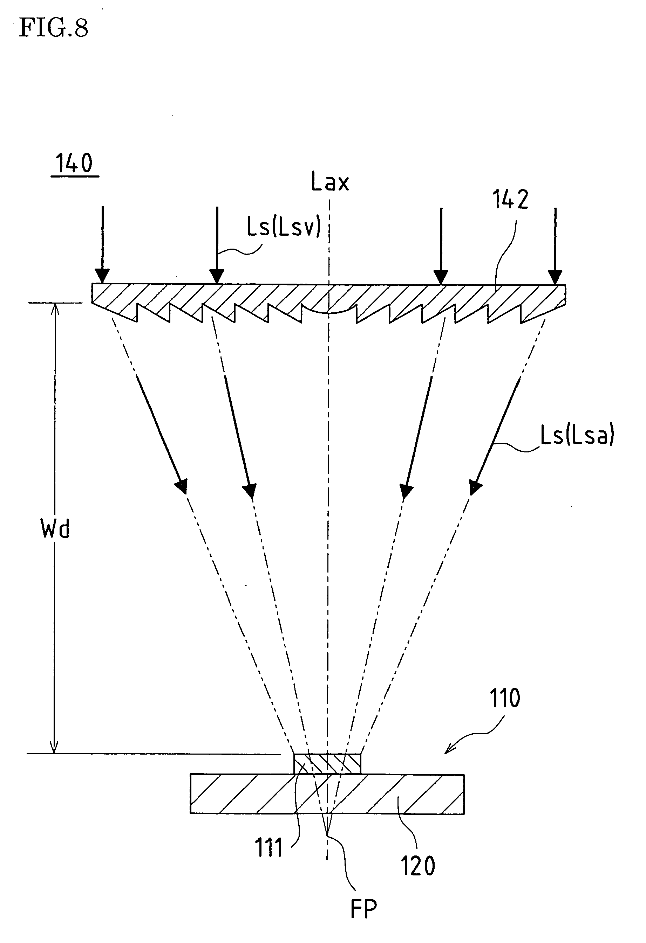

FIG. 8 is a cross-sectional view showing a schematic configuration of a concentrating solar power generation module that is applied to a conventional sun-tracking concentrating solar power generation apparatus.

A concentrating solar power generation module 140 according to this conventional example includes a concentrating lens 142 that receives and concentrates sunlight Ls (sunlight Lsv), and a solar cell 110 that converts the sunlight Ls (sunlight Lsa) concentrated by the concentrating lens 142 into electricity. The solar cell 110 includes a solar cell element 111 that converts the sunlight Lsa concentrated by the concentrating lens 142 into electricity, and a receiver substrate 120 on which the solar cell element 111 is placed. The concentrating lens 142 is configured to have a focal position FP on the back surface side of the solar cell element 111.

The conventional sun-tracking concentrating solar power generation apparatus employs such a concentrating solar power generation module 140, which can provide a high concentration magnification through the action of the concentrating lens 142.

The sun-tracking concentrating solar power generation apparatus having a high concentration magnification has the following problems. The spacing (working distance Wd of the concentrating lens) from the concentrating lens 142 to the solar cell 110 (the solar cell element 111) is large, as a result of which the volume and weight of the concentrating solar power generation module 140 becomes large, increasing the cost of material for the module. In addition, as the module weight increases, a higher tracking capability is required, which increases the overall cost.

In other words, the working distance Wd needs to be shortened in order to achieve a reduction in the module weight and cost.

In order to solve the problems encountered with conventional technology, a secondary optical system is generally provided between a dome-shaped lens or concentrating lens and a solar cell element.

Specifically, a structure has been proposed in which a convex lens is used as a secondary optical system that is disposed immediately above the surface of a solar cell element (see, for example, Patent Document 1). Other than a convex lens, a biconvex lens, a plano-convex lens or a rhombic lens may be used.

Another structure has also been proposed in which another similar Fresnel lens is disposed immediately below the surface of a Fresnel lens serving as a primary optical system (see, for example, Patent Document 2).

Furthermore, another structure has been proposed in which light concentrated by a primary optical system (concentrating lens) is directed into a secondary optical system that is made of a light-transmitting material and that is disposed immediately above a solar cell element, where the light is totally reflected by the side faces to concentrate the light on the surface of the solar cell element (see, for example, Patent Documents 3 and 4).

However, when a biconvex lens or a plano-convex lens is used as a secondary optical system, the problem of chromatic aberrations is aggravated, or problems arise in that the amount of light incident on the solar cell element decreases due to a refractive/transmission loss at the secondary optical system.

The methods disclosed in Patent Documents 1 and 2 are problematic in that the entirety of the light incident on the solar cell element passes through the secondary optical system, so there is a refractive/transmission loss due to the secondary optical system, and thus the actual amount of light incident on the solar cell element decreases.

The methods disclosed in Patent Documents 3 and 4 are effective in solving the problems of alignment error, chromatic aberration and light intensity distribution, but these methods require an increased angle of incidence to the side faces of the secondary optical system in order to cause the light to be totally reflected at the side faces. That is, it is necessary to increase the focal distance of the primary optical system and to install the secondary optical system and the solar cell element away from the primary optical system. Consequently, a problem arises in that the thickness in the direction of the optical axis Lax of the concentrating solar power generation module increases, increasing the total weight.

The weight increase due to the increased thickness of the concentrating solar power generation module increases the size of a sun-tracking mechanism unit (sun-tracking driving system) that incorporates and drives the mounted concentrating solar power generation module, causing the sun-tracking concentrating solar power generation apparatus to have disadvantages, such as increased cost, difficulty in handling, and maintenance difficulties.

The methods disclosed in Patent Documents 3 and 4 also have similar problems to those of Patent Document 1, such as a refractive loss at the incident end face and the emitting end face of the secondary optical system, and a reduction in the amount of light incident on the solar cell element due to the transmission loss at the secondary optical system.

Furthermore, according to the above-described methods using a secondary optical system, because the secondary optical system directly receives sunlight that has been concentrated by the primary optical system to a high density, the members (material) that constitute the secondary optical system are required to have high heat resistance, increasing the cost of the apparatus as a result.

In the case of having a high concentration magnification in particular, the energy density of the concentrated light beam increases. Accordingly, if the concentrated sunlight is directed to a region other than the solar cell element due to a sun-tracking error or the like, the members (components such as wiring) other than the solar cell element may burn out, causing a crack in the glass disposed as an optical member. In other words, there is a problem that it is extremely difficult to obtain a sun-tracking concentrating solar power generation apparatus that has sufficient reliability.

### Prior Art Documents

### Patent Documents

[Patent Document 1] U.S. Patent No. 5167724
[Patent Document 2] U.S. Patent No. 6653551
[Patent Document 3] JP 2002-289897A
[Patent Document 4] JP 2003-258291A

### Summary of Invention

### Problems to be Solved by the Invention

The present invention has been conceived in view of the above circumstances, and it is an object of the present invention to provide a concentrating optical member that can be applied to a solar cell for generating power using concentrated sunlight and that can concentrate sunlight onto a solar cell element, in which by including a first optical member having a first refractive index that is disposed on a side on which sunlight is incident and a second optical member having a second refractive index different from the first refractive index that is disposed on a side on which the solar cell element is located, sunlight that has passed through the first optical member can be converged toward the solar cell element by the second optical member, and the spacing (working distance of the concentrating optical member) between the concentrating optical member and the solar cell element is shortened, as a result of which the property of concentrating sunlight can be improved, and it is possible to provide a small and thin concentrating solar power generation module.

Another object of the present invention is to provide an inexpensive concentrating solar power generation module that can concentrate sunlight onto a solar cell element using a concentrating optical member and that can generate power, in which by applying the concentrating optical member according to the present invention, the property of concentrating sunlight is improved, and the distance (working distance of the concentrating optical member) between the concentrating optical member and the solar cell element is shortened, as a result of which a reduction in thickness and weight is possible, and power generation efficiency is improved.

### Means for Solving the Problems

A concentrating optical member according to the present invention is a concentrating optical member that can be applied to a solar cell for generating power using sunlight concentrated onto a solar cell element and that can concentrate sunlight onto the solar cell element, including: a first optical member having a first refractive index that is disposed on a side on which sunlight is incident and a second optical member having a second refractive index that is disposed on a side on which the solar cell element is located, in which the first refractive index and the second refractive index have different values.

With this configuration, because sunlight that has passed through the first optical member can be converged toward the solar cell element by the second optical member, the spacing (working distance of the concentrating optical member) between the concentrating optical member and the solar cell element can be shortened, as a result of which the property of concentrating sunlight can be improved, and it is possible to obtain a concentrating optical member with which it is possible to provide a small and thin concentrating solar power generation module.

In addition, in the concentrating optical member of the present invention, the first optical member is an imaging lens, and the second optical member is a non-imaging lens.

With this configuration, chromatic aberrations of sunlight concentrated onto the solar cell element can be reduced, and the spot energy density can be suppressed, as a result of which the heat resistance, reliability and weather resistance of the concentrating solar power generation module can be improved.

In addition, in the concentrating optical member of the present invention, the first optical member has an inner surface facing the solar cell element that is convex-shaped, and the second optical member is in close contact with the inner surface of the first optical member.

With this configuration, the first optical member and the second optical member can be combined with ease and high accuracy in an optimized way, as a result of which a loss at the interface between the two members can be suppressed, and light concentration properties can be reliably improved.

In addition, in the concentrating optical member of the present invention, the first optical member has an inner surface facing the solar cell element that is concave-shaped, and the second optical member is in close contact with the inner surface of the first optical member.

With this configuration, the first optical member and the second optical member can be combined with ease and high accuracy in an optimized way, as a result of which a loss at the interface between the two members can be suppressed, and light concentration properties can be reliably improved.

In addition, in the concentrating optical member of the present invention, the second optical member is a Fresnel lens.

With this configuration, a non-imaging lens can be formed with ease and high accuracy, and light concentration properties can be improved with ease and high accuracy.

In addition, in the concentrating optical member of the present invention, the second refractive index is larger than the first refractive index.

With this configuration, the working distance of the concentrating optical member can be shortened, and sunlight can be concentrated onto the solar cell element with ease and high accuracy, as a result of which the size of the concentrating solar power generation module to which the concentrating optical member is applied can be reduced.

In addition, the concentrating optical member of the present invention includes a light-transmitting substrate that is in close contact with an outer surface of the first optical member on which sunlight is incident.

With this configuration, the first optical member can be made thin and the used amount of the first optical member can be reduced while securing mechanical strength and weather resistance, as a result of which it is possible to obtain an inexpensive and highly reliable concentrating optical member.

In addition, the concentrating optical member of the present invention includes an anti-reflection film that is formed on an outer surface of the light-transmitting substrate.

With this configuration, sunlight is prevented from being reflected at the outer surface of the light-transmitting substrate on which the sunlight is incident, and degradation of the concentrating optical member can be prevented, as a result of which it is possible to produce a highly reliable concentrating solar power generation module with improved weather resistance and power generation efficiency.

In addition, the concentrating optical member of the present invention includes an anti-reflection film that is formed on an outer surface of the first optical member.

With this configuration, sunlight is prevented from being reflected at the outer surface of the first optical member on which the sunlight is incident, and degradation of the concentrating optical member can be prevented, as a result of which it is possible to produce a highly reliable concentrating solar power generation module with improved weather resistance and power generation efficiency.

A concentrating solar power generation module according to the present invention is a concentrating solar power generation module that can concentrate sunlight onto a solar cell element using a concentrating optical member and that can generate power, in which the concentrating optical member is the concentrating optical member according to the present invention.

With this configuration, the property of concentrating sunlight can be improved, and the distance (working distance of the concentrating optical member) between the concentrating optical member and the solar cell element can be shortened, as a result of which it is possible to obtain a thin, light-weight and inexpensive concentrating solar power generation module with improved power generation efficiency.

### Effects of the Invention

The concentrating optical member of the present invention is a concentrating optical member that can be applied to a solar cell for generating power using sunlight concentrated onto a solar cell element and that can concentrate sunlight onto the solar cell element, including a first optical member having a first refractive index that is disposed on a side on which sunlight is incident and a second optical member having a second refractive index that is disposed on a side on which the solar cell element is located, in which the first refractive index and the second refractive index have different values, and therefore, sunlight that has passed through the first optical member can be converged toward the solar cell element by the second optical member, and the spacing (working distance of the concentrating optical member) between the concentrating optical member and the solar cell element can be shortened, as a result of which it is possible to achieve the effects of improving the property of concentrating sunlight and providing a concentrating optical member with which it is possible to provide a small and thin concentrating solar power generation module.

The concentrating solar power generation module according to the present invention is a concentrating solar power generation module that can concentrate sunlight onto a solar cell element using a concentrating optical member and that can generate power, in which the concentrating optical member is the concentrating optical member according to the present invention, and therefore, the property of concentrating sunlight can be improved, and the distance (working distance of the concentrating optical member) between the concentrating optical member and the solar cell element can be shortened, as a result of which it is possible to achieve the effects of providing a thin, light-weight and inexpensive concentrating solar power generation module with improved power generation efficiency.

### Brief Description of Drawings

[FIG. 1] FIG. 1 is a cross-sectional view showing a schematic configuration of a concentrating optical member and a concentrating solar power generation module according to Embodiment 1 of the present invention.
[FIG. 2] FIG. 2 is a plan view of the concentrating optical member shown in FIG. 1 as viewed from the side on which sunlight is incident.
[FIG. 3] FIG. 3 is a cross-sectional view showing a variation of the concentrating optical member and the concentrating solar power generation module shown in FIG. 1.
[FIG. 4] FIG. 4 is a cross-sectional view showing a schematic configuration of a concentrating optical member and a concentrating solar power generation module according to Embodiment 2 of the present invention.
[FIG. 5] FIG. 5 is a cross-sectional view showing a variation of the concentrating optical member and the concentrating solar power generation module shown in FIG. 4.
[FIG. 6A] FIG. 6A is a cross-sectional view showing a schematic configuration of a solar cell according to Embodiment 3 of the present invention.
[FIG. 6B] FIG. 6B is a cross-sectional view showing a variation of the solar cell shown in FIG. 6A.
[FIG. 7] FIG. 7 is a cross-sectional view showing a schematic configuration of a concentrating optical member and a concentrating solar power generation module according to Embodiment 4 of the present invention.
[FIG. 8] FIG. 8 is a cross-sectional view showing a schematic configuration of a concentrating solar power generation module applied to a conventional sun-tracking concentrating solar power generation apparatus.

### Modes for Carrying out the Invention

Hereinafter, embodiments of the present invention will be described with reference to the drawings.

### Embodiment 1

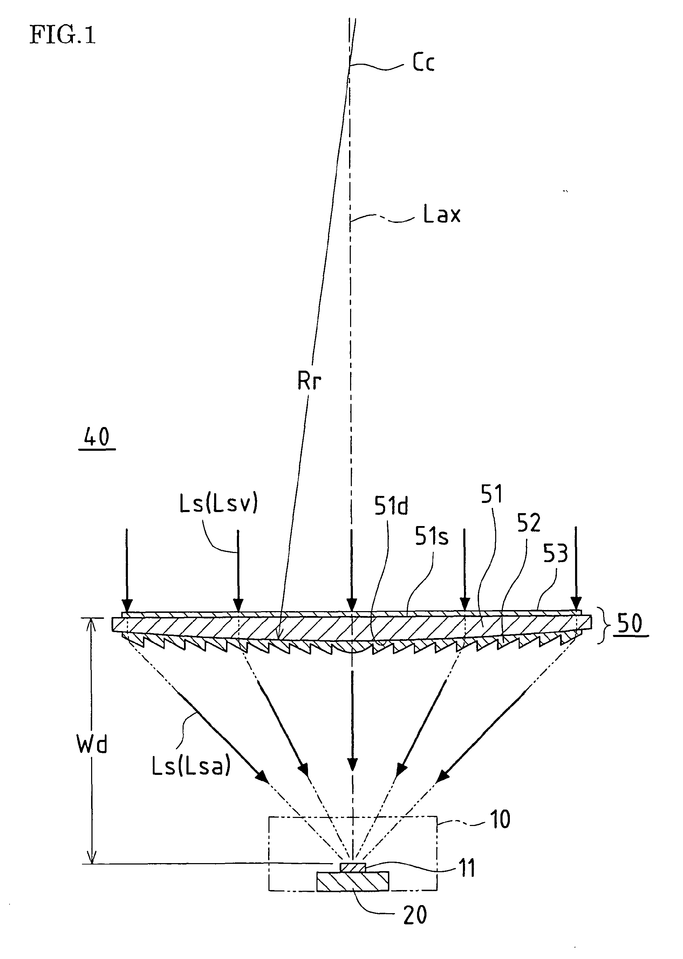

A concentrating optical member and a concentrating solar power generation module according to the present embodiment will be described with reference to FIGS. 1 to 3.

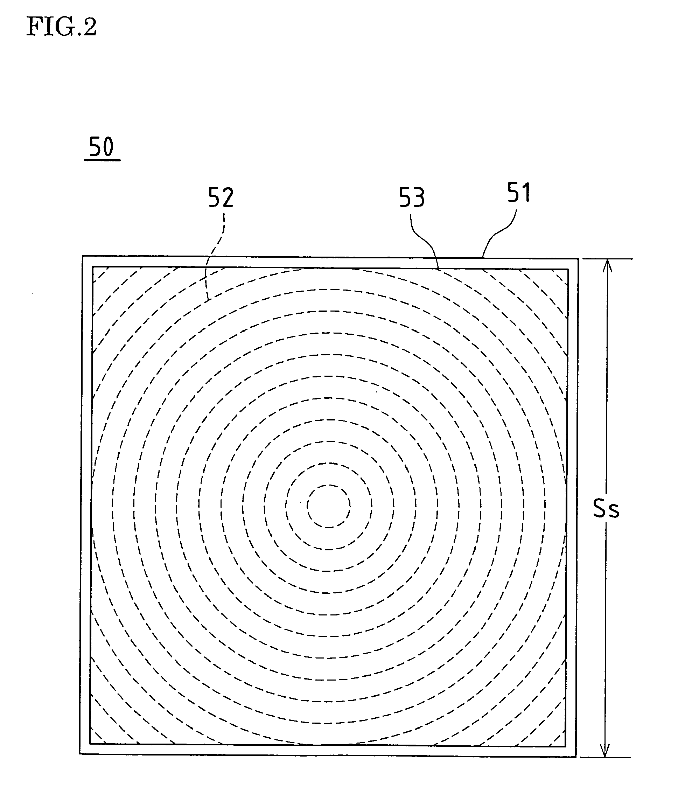

FIG. 1 is a cross-sectional view showing a schematic configuration of a concentrating optical member and a concentrating solar power generation module according to Embodiment 1 of the present invention. FIG. 2 is a plan view of the concentrating optical member shown in FIG. 1 as viewed from the side on which sunlight is incident.

A concentrating optical member 50 according to the present embodiment can be applied to a solar cell 10 that generates power using sunlight Lsa concentrated onto a solar cell element 11, and is configured to concentrate sunlight Lsa onto the solar cell element 11. The solar cell element 11 is mounted on a receiver substrate 20. The configuration of the solar cell 10 will be described in further detail in Embodiment 3.

A concentrating solar power generation module 40 according to the present embodiment includes the solar cell 10 and the concentrating optical member 50. The concentrating optical member 50 is configured so as to exactly face the sun by the action of a sun-tracking mechanism (not shown). Accordingly, sunlight Ls enters the concentrating optical member 50 perpendicularly (in the direction parallel to the optical axis Lax) as sunlight Lsv. The concentrating optical member 50 is also configured to concentrate sunlight Lsa, which is refracted sunlight Lsv, onto the solar cell 10 (the solar cell element 11).

Specifically, the sunlight Lsa is obtained by concentrating sunlight Lsv that is incident parallel to the optical axis Lax of a first optical member 51 from a direction perpendicular to the first optical member 51 toward a direction of the solar cell element 11. Hereinafter, the sunlight Lsv and the sunlight Lsa are referred to simply as sunlight Ls, where it is unnecessary to distinguish them.

The concentrating optical member 50 includes the first optical member 51 having a first refractive index that is disposed on the side on which sunlight Ls is incident and a second optical member 52 having a second refractive index that is disposed on the side on which the solar cell element 11 is located. The first refractive index and the second refractive index have different values. In other words, the concentrating optical member 50 has a configuration in which the first optical member 51 and the second optical member 52 are laid over one another.

Accordingly, sunlight Ls that has passed through the first optical member 51 is converged toward the solar cell element 11 by the second optical member 52, and therefore the spacing (working distance Wd of the concentrating optical member 50) between the concentrating optical member 50 and the solar cell element 11 can be shortened, as a result of which the property of concentrating sunlight Ls can be improved, and a concentrating optical member 50 with which it is possible to provide a small and thin concentrating solar power generation module 40 can be obtained.

The first optical member 51 has an inner surface 51d facing the solar cell element 11 that is convex-shaped, and the second optical member 52 is in close contact with the inner surface 51d of the first optical member 51. Accordingly, the first optical member 51 and the second optical member 52 can be combined with ease and high accuracy in an optimized way, as a result of which a loss at the interface between the two members can be suppressed, and light concentration properties can be reliably improved.

In other words, the first optical member 51 has a spherical surface (the inner surface 51d) having a radius Rr from a center Cc that is on the optical axis Lax on the side on which sunlight Ls is incident. The second optical member 52 can be, for example, a Fresnel lens, and is configured so as to concentrate sunlight Ls that has entered via the first optical member 51 onto the solar cell element 11.

By configuring the second optical member 52 with a Fresnel lens, a non-imaging lens can be formed with ease and high accuracy, and light concentration properties can be improved with ease and high accuracy.

As described above, the first optical member 51 is configured with an imaging lens, and the second optical member 52 is configured with a non-imaging lens.

Accordingly, chromatic aberrations of sunlight Ls concentrated onto the solar cell element 11 can be reduced, and the spot energy density can be suppressed, as a result of which the heat resistance, reliability and weather resistance of the concentrating solar power generation module 40 can be improved.

In the present embodiment, the refractive index (second refractive index) of the second optical member 52 is set larger than the refractive index (first refractive index) of the first optical member 51. Accordingly, the working distance Wd can be shortened, and sunlight Ls can be concentrated onto the solar cell element 11 with ease and high accuracy, as a result of which the size of the concentrating solar power generation module 40 to which the concentrating optical member 50 is applied can be reduced. The refractive indexes can be adjusted by selecting appropriate material for the first optical member 51 and the second optical member 52, as will be described later.

The concentrating optical member 50 includes an anti-reflection film 53 that is formed on an outer surface 51s of the first optical member 51. Accordingly, sunlight Ls is prevented from being reflected at the outer surface 51s of the first optical member 51 on which the sunlight Ls is incident, and degradation of the concentrating optical member 50 can be prevented, as a result of which it is possible to produce a highly reliable concentrating solar power generation module 40 with improved weather resistance and power generation efficiency.

As described above, the concentrating solar power generation module 40 of the present embodiment concentrates sunlight Ls onto the solar cell element 11 using the concentrating optical member 50 and generates power. Accordingly, the property of concentrating sunlight Ls can be improved, and the distance (working distance Wd of the concentrating optical member 50) between the concentrating optical member 50 and the solar cell element 11 can be shortened, as a result of which it is possible to obtain a thin, light-weight and inexpensive concentrating solar power generation module 40 with improved power generation efficiency.

The first optical member 51 can be made of, for example, acrylic resin having superior weather resistance, and the second optical member 52 can be made of, for example, polycarbonate. At this time, the acrylic resin has a refractive index (first refractive index) of 1.49 to 1.51, and the polycarbonate has a refractive index (second refractive index) of 1.58 to 1.60. In other words, as described above, it is desirable that the refractive index (second refractive index) of the second optical member 52 is larger than the refractive index (first refractive index) of the first optical member 51.

The first optical member 51 has a cross-sectional thickness of, for example, approximately 3 mm to 5 mm. In order to efficiently concentrate sunlight Ls, the planar shape of the concentrating optical member 50 is made square with a side length Ss of, for example, approximately 150 mm to 250 mm.

The radius Rr of the inner surface 51d (spherical surface) of the first optical member 51 can be set to approximately 1 to 5 times the side length Ss. In the present embodiment, the radius Rr is set to approximately 1.5 times the side length Ss.

When acrylic resin is used as a first optical member 51 and polycarbonate is used as a second optical member 52, a concentrating optical member 50 can be produced by the following procedure. Firstly, a first optical member 51 (acrylic resin) and a second optical member 52 (polycarbonate) are molded at a thermoforming temperature using their corresponding dies.

Next, the first optical member 51 and the second optical member 52 are intimately bonded at a temperature close to the softening temperatures of acrylic resin and polycarbonate, and thereafter cooled to room temperature in an annealing step, whereby a concentrating optical member 50 in which the first optical member 51 and the second optical member 52 are laid over one another can be formed. If necessary, an anti-reflection film 53 is laminated/formed on the outer surface 51s of the first optical member 51.

The anti-reflection film 53 can be made of, for example, titanium oxide (Ti0₂), aluminum oxide (Al₂O₃), magnesium fluoride (MgF₂) or the like, and as the production method, sputtering, vacuum deposition or the like can be used.

As the combination of materials of the first optical member 51 and the second optical member 52, the following combination of materials can be used other than that described above. Specifically, if glass having a low refractive index (e.g., a first refractive index of approximately 1.43 to 1.45) is used as the first optical member 51, then the second optical member 52 can be made of, for example, acrylic resin, polycarbonate, silicone resin or the like.

When glass is used as the first optical member 51, and acrylic resin, polycarbonate, silicone resin or the like is used as the second optical member 52, then the concentrating optical member 50 can be formed at a temperature less than or equal to 100°C.

That is, the concentrating optical member 50 can be formed by thermally solidifying (or optically solidifying) glass that has been brought into contact with a resin injected into a die corresponding to the second optical member 52, and thereby intimately bonding the first optical member 51 to the second optical member 52.

The materials of the first optical member 51 and the second optical member 52 that constitute the concentrating optical member 50 are not limited to the materials described above. To prevent ultraviolet light degradation of the concentrating optical member 50, it is possible to add an appropriate ultraviolet light absorber.

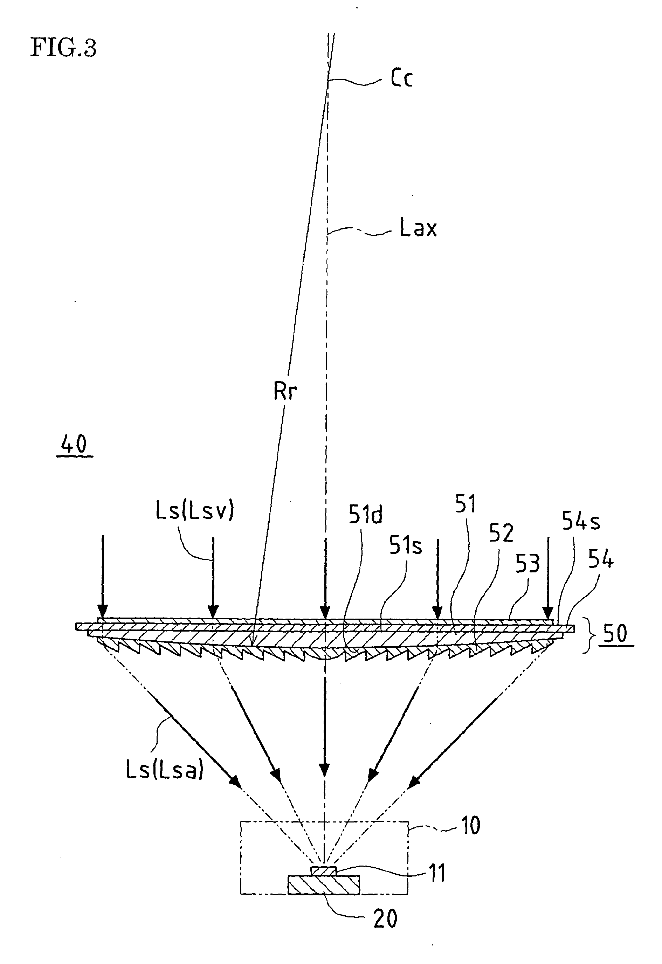

FIG. 3 is a cross-sectional view showing a variation of the concentrating optical member and the concentrating solar power generation module shown in FIG. 1.

The basic configurations of a concentrating optical member 50 and a concentrating solar power generation module 40 according to this variation are the same as those of the concentrating optical member 50 and the concentrating solar power generation module 40 shown in FIG. 1, and thus the same reference numerals are given, and mainly the differences will be described here.

The concentrating optical member 50 of this variation includes a light-transmitting substrate 54 having two parallel flat surfaces. That is, the light-transmitting substrate 54 that is in close contact with the outer surface 51s, on which sunlight Ls is incident, of the first optical member 51 is included. Accordingly, the first optical member 51 can be made thin and the used amount of the first optical member 51 can be reduced while securing mechanical strength and weather resistance, as a result of which it is possible to obtain an inexpensive and highly reliable concentrating optical member 50.

As the light-transmitting substrate 54, glass, weather resistance grade acrylic resin which is inexpensive, polycarbonate or the like can be used, but a glass plate is used in the present embodiment. In this variation, because the light-transmitting substrate 54 is disposed on the outer surface 51s of the first optical member 51, it is not possible to form an anti-reflection film 53 on the outer surface 51s.

Accordingly, in this variation, the anti-reflection film 53 is formed on an outer surface 54s of the light-transmitting substrate 54. Accordingly, sunlight Ls is prevented from being reflected at the outer surface 54s of the light-transmitting substrate 54 on which the sunlight Ls is incident, and degradation of the concentrating optical member 50 can be prevented, as a result of which it is possible to produce a highly reliable concentrating solar power generation module 40 with improved weather resistance and power generation efficiency.

### Embodiment 2

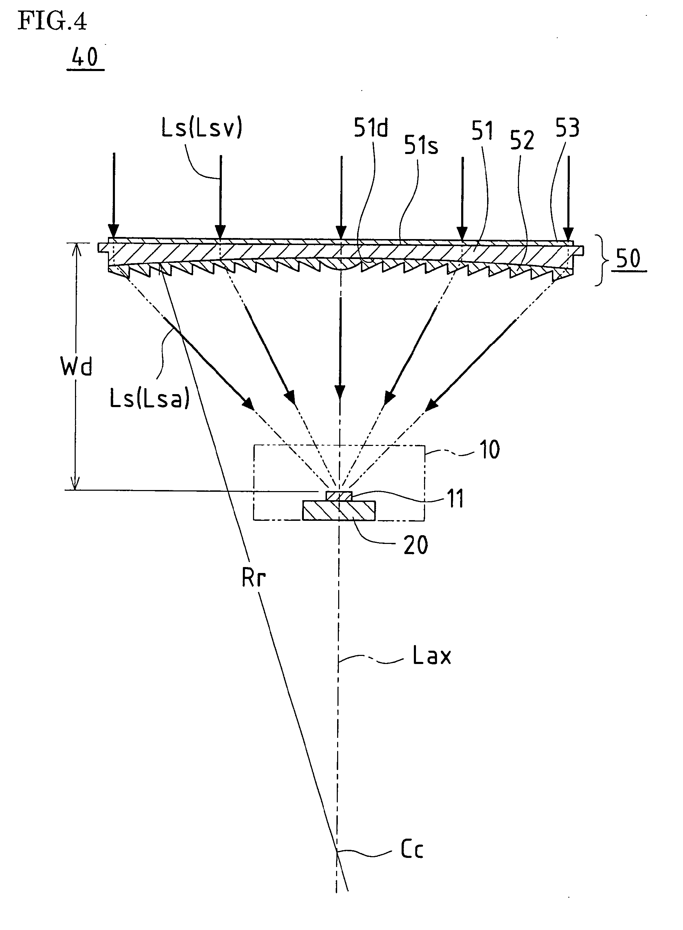

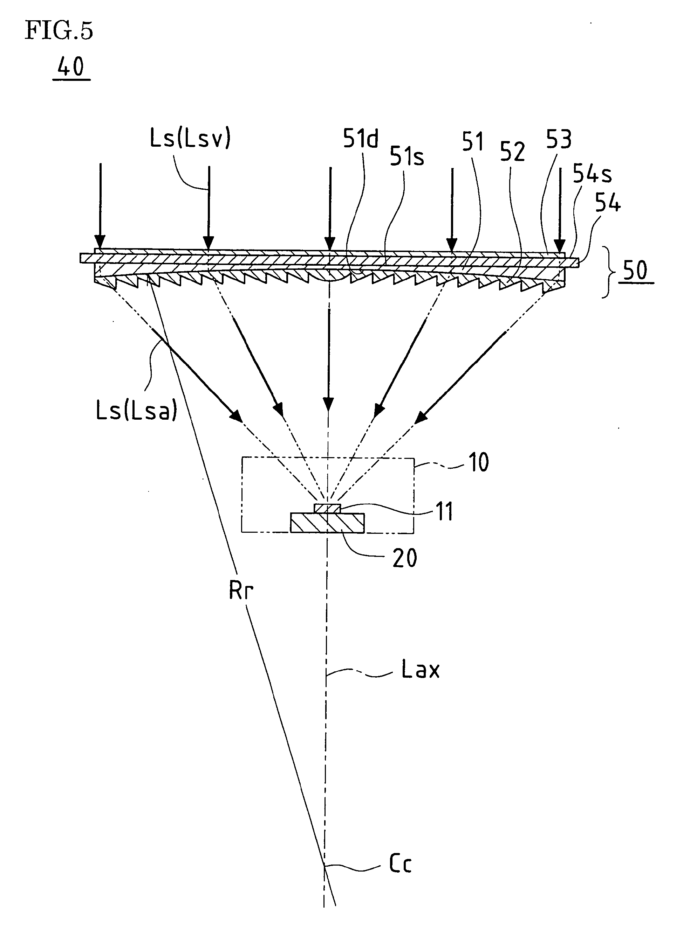

A concentrating optical member and a concentrating solar power generation module according to the present embodiment will be described with reference to FIGS. 4 and 5.

FIG. 4 is a cross-sectional view showing a schematic configuration of a concentrating optical member and a concentrating solar power generation module according to Embodiment 2 of the present invention.

The basic configurations of a concentrating optical member 50 and a concentrating solar power generation module 40 of the present embodiment are the same as those of the concentrating optical member 50 and the concentrating solar power generation module 40 shown in Embodiment 1, and thus the same reference numerals are given, and mainly the differences will be described here.

In the concentrating optical member 50 of the present embodiment, the first optical member 51 having the convex-shaped inner surface 51d shown in FIG. 1 has been replaced with a first optical member 51 having a concave-shaped inner surface 51d.

Specifically, in the concentrating optical member 50 of the present embodiment, the inner surface 51d of the first optical member 51 faces the solar cell element 11, which is concave, and the second optical member 52 is in close contact with the inner surface 51d of the first optical member 51. Accordingly, the first optical member 51 and the second optical member 52 can be combined with ease and high accuracy in an optimized way, as a result of which a loss at the interface between the two members can be suppressed, and light concentration properties can be reliably improved.

In other words, the first optical member 51 has a spherical surface (the inner surface 51d) having a radius Rr from a center Cc that is on the optical axis Lax on the side on which sunlight Ls is incident.

The other constituent elements are the same as those of the concentrating optical member 50 and the concentrating solar power generation module 40 shown in FIG. 1, and thus descriptions thereof are omitted here.

FIG. 5 is a cross-sectional view showing a variation of the concentrating optical member and the concentrating solar power generation module.

The basic configurations of a concentrating optical member 50 and a concentrating solar power generation module 40 according to this variation are the same as those of the concentrating optical member 50 and the concentrating solar power generation module 40 shown in FIG. 4, and thus the same reference numerals are given, and mainly the differences will be described here.

The concentrating optical member 50 of this variation includes a light-transmitting substrate 54 having two parallel flat surfaces. That is, it includes a light-transmitting substrate 54 that is in close contact with the outer surface 51s, on which sunlight Ls is incident, of the first optical member 51, which is concave. Accordingly, the first optical member 51 can be made thin and the used amount of the first optical member 51 can be reduced while securing mechanical strength and weather resistance, as a result of which it is possible to obtain an inexpensive and highly reliable concentrating optical member 50.

In this variation, the variation described in Embodiment 1 (FIG. 3) is applied to the concentrating optical member 50 shown in FIG. 4, and therefore the basic configuration is the same as described with reference to FIG. 3, and a detailed description thereof is omitted here.

### Embodiment 3

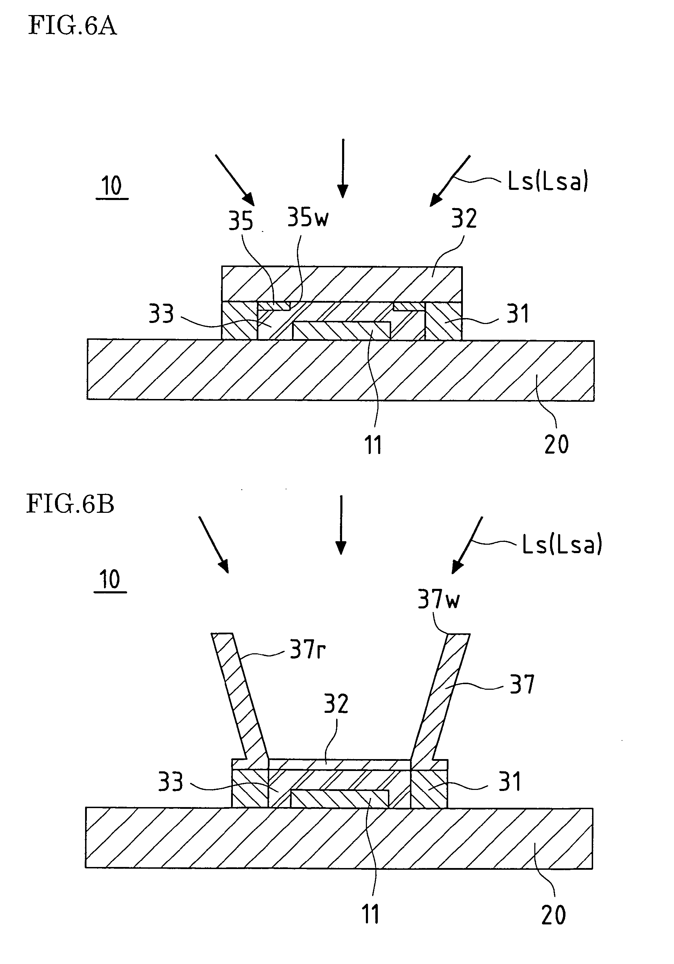

A solar cell that can be applied to the concentrating optical member and the concentrating solar power generation module according to Embodiments 1 and 2 will be described with reference to FIGS. 6A and 6B as Embodiment 3.

FIG. 6A is a cross-sectional view showing a schematic configuration of a solar cell according to Embodiment 3 of the present invention.

In a solar cell 10 according to the present embodiment, a solar cell element 11 is mounted on a receiver substrate 20. The solar cell 10 includes a sealing frame 31 that is disposed on the outer periphery of the solar cell element 11, a light-transmitting covering plate 32 that is placed on the sealing frame 31 and that is disposed facing the solar cell element 11 so as to protect the solar cell element 11 from the external environment, and a resin sealing portion 33 that resin-seals the space between the solar cell element 11 and the light-transmitting covering plate 32.

In the solar cell 10, a reflecting portion 35 that prevents irradiation of the receiver substrate 20 with sunlight Ls is provided on a face facing the resin sealing portion 33 of the light-trarismitting covering plate 32. The reflecting portion 35 has a light-transmitting window 35w that defines sunlight Ls directed to the solar cell element 11. Accordingly, when the concentrating optical member 50 is in the normal position, sunlight Ls is reliably concentrated onto the solar cell element 11.

If concentrated sunlight Lsa deviates due to a sun tracking error of the concentrating solar power generation module 40, or a positioning error between the concentrating optical member 50 and the solar cell 10 or the like, and is directed to the reflecting portion 35 on the outer periphery of the light-transmitting window 35w, the sunlight Ls is reflected to the outside by the reflecting portion 35. Accordingly, the receiver substrate 20 is not irradiated with deviated sunlight Ls.

In other words, the reflecting portion 35 prevents unnecessary sunlight Ls from being directed to the receiver substrate 20, and prevents a temperature increase at the surface of the receiver substrate 20, and thus wiring members disposed on the surface of the receiver substrate 20 can be prevented from damage, as a result of which it is possible to obtain a highly reliable solar cell 10 and concentrating solar power generation module 40.

With the reflecting portion 35, even in the case of a high concentration magnification of, for example, 600 SUN (1 SUN = 100 mW/m²) or more, it is possible to prevent the wirings (organic members) and the like of the receiver substrate 20 from being burnt, and the light-transmitting covering plate 32 from being cracked, so a highly efficient and inexpensive solar cell 10 having improved heat resistance, high reliability and high weather resistance can be obtained. The reflecting portion 35 can effectively reflect sunlight Ls by being made of, for example, a metallic film.

The solar cell element 11 is made of an inorganic material, such as Si, GaAs, CuInGaSe or CdTe. The structure of the solar cell element 11 can be any of various structures, such as a single-junction cell, a monolithic multi-junction cell, and a mechanical stack in which various solar cells having different wavelength sensitivity ranges are connected.

It is desirable that the outer size of the solar cell element 11 is, for example, approximately several to 10 mm from the viewpoint of achieving a reduction in the amount of solar cell material used, the ease and simplification of processing/procedure, cost, and the like.

In the receiver substrate 20, a connection pattern (not shown) that is connected to desired wiring (an electrode of the solar cell element 11 (not shown)) and that performs output to the outside, or a connection pattern (not shown) for connecting solar cell elements 11 in series or in parallel is formed on a metallic base such as an aluminum plate or copper plate with an appropriate insulating layer interposed therebetween.

In other words, a configuration is employed in which the current generated by the solar cell element 11 is output to the outside of the solar cell 10 with the wiring formed in the receiver substrate 20 as appropriate. Because the wiring formed in the receiver substrate 20 is required to secure highly reliable insulation capabilities, a configuration is employed, for example, in which insulation is provided by covering the connection pattern made of a copper foil with an insulating film such as an organic material.

The light-transmitting covering plate 32 is made of, for example, a glass plate (heat-resistant glass), and secures heat resistance and moisture resistance to improve weather resistance. The light-transmitting covering plate 32 is configured to have a thickness that can suppress the irradiation intensity of sunlight Ls at the surface of the light-transmitting covering plate 32 to, for example, approximately 320 kW/m² or less so as to secure heat resistance. In order to reduce the light reflection coefficient in the wavelength sensitivity range of the solar cell 10, it is also possible to provide a suitable anti-reflection film or the like on the surface of the light-transmitting covering plate 32.

The resin sealing portion 33 is made of an insulating resin, such as a transparent silicone resin, filled between the solar cell element 11 and the light-transmitting covering plate 32 to cause the sunlight Ls that has passed through the light-transmitting covering plate 32 to be directed to the solar cell element 11.

The solar cell element 11 that constitutes the solar cell 10 applied to the concentrating solar power generation module 40 is particularly required to have high efficiency and practical usefulness, and therefore it is desirable to use an InGaP/GaAs/Ge triple-junction solar cell element, an AlGaAs/Si solar cell element, or a monolithic multi-junction solar cell element.

The surface of the solar cell element 11 that converts sunlight Ls into electricity is disposed in parallel with the sunlight Ls incident face of the concentrating optical member 50, and the sunlight Ls incident and emitting faces of the light-transmitting covering plate 32.

FIG. 6B is a cross-sectional view showing a variation of the solar cell shown in FIG. 6A.

The basic configuration of a solar cell 10 according to this variation is the same as that of the solar cell 10 shown in FIG. 6A, and thus the same reference numerals are given, and mainly the differences will be described here.

In the solar cell 10 of this variation, as in the solar cell 10 shown in FIG. 6A, a solar cell element 11 is mounted on a receiver substrate 20. The solar cell 10 includes a sealing frame 31 that is disposed on the outer periphery of the solar cell element 11, a light-transmitting covering plate 32 that is placed on the sealing frame 31 and that is disposed facing the solar cell element 11 so as to protect the solar cell element 11 from the external environment, and a resin sealing portion 33 that resin-seals the space between the solar cell element 11 and the light-transmitting covering plate 32.

In the solar cell 10 of this variation, an inclined reflecting portion 37 is provided in place of the reflecting portion 35 of the solar cell 10 shown in FIG. 6A. The inclined reflecting portion 37 has an inclined reflecting face 37r that opens toward the concentrating optical member 50, and is provided in contact with the sealing frame 31.

Because the inclined reflecting portion 37 has the inclined reflecting face 37r, sunlight Ls (sunlight Lsa) that has been concentrated toward the solar cell 10 can be effectively converged to the solar cell element 11, and light concentration properties can be further improved. In addition, because there is an opening 37w, even if the sunlight Ls concentrated by the concentrating optical member 50 deviates, the sunlight Ls can be efficiently converged and guided to the solar cell element 11, as a result of which light concentration properties can be improved.

The inclined reflecting portion 37 can be made from, for example, a metal material. It is desirable to use, as the metal material, aluminum (aluminum plate) or SUS (Steel Use Stainless: stainless steel material, stainless steel plate), considering productivity, safety and reliability. An aluminum alloy may be incorporated into the aluminum.

The inclined reflecting portion 37r may be configured to have a glossy surface (mirror finished surface) by being subjected to mirror finishing, and thereby the sunlight Ls can be more effectively concentrated toward the solar cell element 11.

In this variation, an SUS plate having a thickness of approximately 1.5 mm is used as the inclined reflecting portion 37. Also, the inclined reflecting portion 37r has a mirror finished surface, and a protection film made of a silicon oxide film (SiOx) is formed. As a result, a reflection coefficient at a wavelength of 400 nm to 1200 nm of not less than 60% is obtained.

As described above, according to this variation, because the inclined reflecting portion 37r is provided, the sunlight Ls can be concentrated toward the solar cell element 11 with ease and high accuracy, as a result of which light concentration properties can be reliably improved, and power generation efficiency can be improved.

The inclined reflecting portion 37 is provided in contact with the sealing frame 31, but the inclined reflecting portion 37 may be provided upright directly on the receiver substrate 20.

The solar cell 10 according to the present embodiment is not limited to the configuration described above, and various modifications can be made as long as it fits to the concentrating optical member 50 of Embodiments 1 and 2.

### Embodiment 4

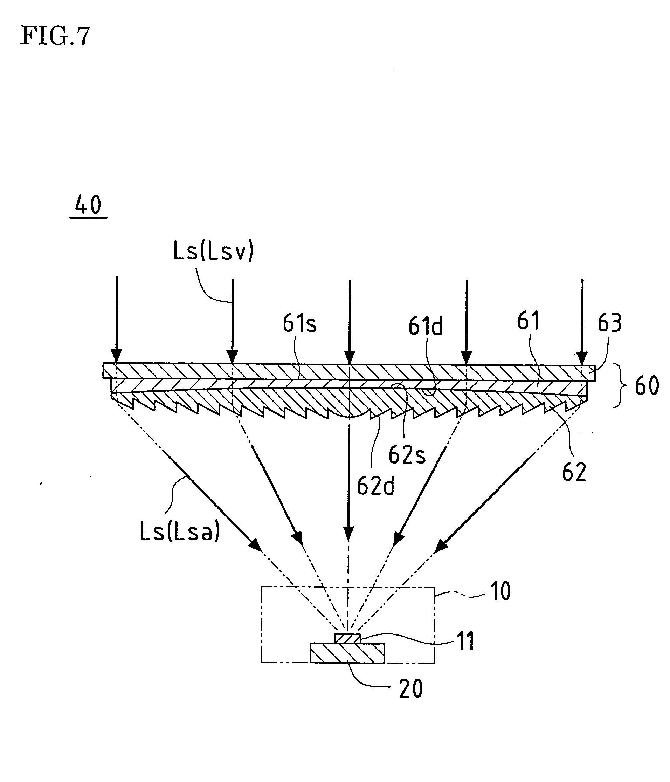

A concentrating optical member and a concentrating solar power generation module according to the present embodiment will be described with reference to FIG. 7.

FIG. 7 is a cross-sectional view showing a schematic configuration of a concentrating optical member and a concentrating solar power generation module according to Embodiment 4 of the present invention.

The basic configurations of a concentrating optical member 60 and a concentrating solar power generation module 40 of the present embodiment are the same as those of the concentrating optical member 50 and the concentrating solar power generation module 40 shown in Embodiment 1, and thus the same reference numerals are given, and mainly the differences will be described here. The solar cell 10 shown in Embodiment 3 can be applied to the present embodiment as well.

The concentrating optical member 60 according to the present embodiment is configured as a compound type lens, and includes a glass plate 63 serving as a light-transmitting substrate, a first optical member 61 having a first refractive index that is disposed on the side on which sunlight Ls is incident, and a second optical member 62 having a second refractive index that is disposed on the side on which the solar cell element 11 is located. The first refractive index and the second refractive index have different values. In other words, the concentrating optical member 60 has a configuration in which the glass plate 63 serving as a light-transmitting substrate, the first optical member 61 and the second optical member 62 are laid over one another in this order.

The glass plate 63 is formed as a light-transmitting substrate having two parallel flat surfaces. The first optical member 61 is formed as a concave lens in which an outer surface 61s of the first optical member 61 on which sunlight Ls is incident is in close contact with the glass plate 63, and an inner surface 61d facing the solar cell element 11 has a concave shape. The second optical member 62 is formed as a convex lens whose both surfaces are convex-shaped in which an outer surface 62s of the second optical member 62 on which sunlight Ls is incident is in close contact with the inner surface 61d of the first optical member 61, and an inner surface facing the solar cell element 11 has a convex shape.

Accordingly, the concentrating optical member 60 causes sunlight Ls that has passed through the glass plate 63 and the first optical member 61 to be diverged on the light receiving face of the second optical member 62 as non-imaging weak sunlight and to be converged toward the solar cell element 11 from the light emitting face of the second optical member 62. By combining the first optical member 61 configured as a concave lens that brings about a weak scattering effect and the second optical member 62 configured as a convex lens having a light concentration effect as described above, it is possible to form a compound type lens for a concentrating solar cell in which chromatic aberrations of a conventional lens are suppressed.

In the present embodiment, as the first optical member 61, for example, a concave diverging lens made of silicone resin is used, and the refractive index at a wavelength of 600 nm at the use temperature of 20°C is 1.41. As the second optical member 62, a convex concentrating Fresnel lens made of acrylic resin material is used, and the refractive index at a wavelength of 600 nm at the use temperature of 20°C is 1.51.

A concentrating optical member 60 in which silicone resin is used as a first optical member 61 and acrylic resin is used as a second optical member 62 can be produced in the following procedure, for example. Firstly, a first optical member 61 is formed on a glass plate 63 by thermally solidifying the glass plate 63 that has been brought into contact with a resin injected into a die corresponding to the first optical member 61 having a concave-shaped surface. The thermal solidification temperature at this time is approximately 150°C.

Next, acrylic resin is molded into an acrylic Fresnel lens, which will serve as a second optical member 62, using a die having the shape of a Fresnel lens. The acrylic Fresnel lens is formed on the first optical member 61 in a low vacuum state by a thermal solidification method. The thermoforming temperature at this time is approximately 100°C.

As described above, the concentrating lens applied to the concentrating solar cell module 40 according to the present embodiment is a compound type lens that can suppress chromatic aberrations.

Up to here, the present embodiment has been described. The present embodiment has the following effects.

Specifically, by using the technique for shortening the spacing (the working distance Wd of the concentrating optical member) between the concentrating optical member and the solar cell element that shortens the focal distance according to the present embodiment, the light intensity distribution in the light receiving face of the solar cell element can be controlled to be more uniform, as a result of which non-uniformity of power generation current within the cell can be eliminated, and the reduction of the power generation efficiency due to local heat generation or the like can be prevented.

In other words, when a conventional Fresnel lens is used, the concentrating focal points (working distances Wd) of different wavelengths differ in accordance with the wavelength dependency of the refractive index. Generally, this phenomenon is called "chromatic aberration", and when a simple lens is used, the light intensity distribution at the light receiving face of the solar cell element becomes non-uniform due to the chromatic aberration. To cope with such a problem caused by chromatic aberrations, a secondary optical prism is generally employed in the concentrating system.

However, with the compound lens applied to the concentrating solar power generation module of the present embodiment, it is possible to suppress the chromatic aberrations of a conventional lens, and miniaturize or omit the secondary optical prism. Consequently, the receiver structure can be simplified, as a result of which the property of concentrating sunlight can be improved and a more inexpensive concentrating solar power generation module can be obtained.

The chromatic aberrations of the concentrating lens significantly affect the output characteristics of the solar cell element by the distribution of radiation energy density within the surface of the solar cell element. Due to variations in the radiation energy density, the light concentration efficiency of the lens decreases, and the fill factor (FF) of the solar cell element is easily affected by non-uniform distribution due to the wavelengths within the light receiving face of the solar cell element.

The concentrating solar power generation module according to the present embodiment can use various types of high efficiency solar cells. Examples include a high efficiency monocrystalline silicon solar cell, a high efficiency CIS solar cell, a GaAs compound semiconductor solar cell, and the like.

For example, the solar cell 10 may be configured such that a triple-junction compound semiconductor tandem solar cell element 11 having a three-layer structure including InGaP, InGaAs and Ge is mounted on a receiver substrate 20 made of an aluminum plate, and the receiver substrate 20 is attached to a plate (not shown) that is provided with heat dissipation fins (not shown) and that serves as a heat sink. The spectral range of the triple-junction solar cell ranges from 280 nm to 2000 nm in wavelength, and in a solar cell element of a type in which a plurality of power generation layers having different wavelength ranges that significantly contribute to power generation are laminated, the power generation current densities of the layers are preferably equal. Furthermore, it is preferable that the power generation current densities within the light receiving face of the solar cell element are uniform, and by controlling the light intensity distribution of the light receiving face of the solar cell element to be uniform for each wavelength range, the power generation current densities of the layers become uniform within the light receiving face of the solar cell element, and the conversion efficiency of the solar cell element is improved.

As described above, suppressing chromatic aberrations of the concentrating lens is a very important technique, and the present invention has significant effects in this respect as well.

The present invention may be embodied in various other forms without departing from the gist or essential characteristics thereof. Therefore, the embodiments disclosed in this application are to be considered in all respects as illustrative and not limiting. The scope of the invention is indicated by the appended claims rather than by the foregoing description, and all modifications or changes that come within the meaning and range of equivalency of the claims are intended to be embraced therein.

This application claims priority on Japanese Patent Application No. 2008-100478 filed in Japan on April 8, 2008, the entire content of which is incorporated herein by reference. Furthermore, the entire contents of references cited in the present specification are herein specifically incorporated by reference.

### Industrial Applicability

With the present invention, it is possible to provide a concentrating optical member in which light concentration properties are improved by shortening the working distance between the concentrating optical member and the solar cell element and suppressing chromatic aberrations of the concentrating lens, and with which it is possible to provide a small and thin concentrating solar power generation module, and a concentrating solar power generation module to which such a concentrating optical member is applied, and therefore the present invention is useful.

### Description of Reference Numerals

- 10: Solar Cell
- 11: Solar Cell Element
- 20: Receiver Substrate
- 31: Sealing Frame
- 32: Light-Transmitting Covering Plate
- 33: Resin Sealing Portion
- 35: Reflecting Portion
- 35w: The Light-Transmitting Window
- 37: Inclined Reflecting Portion
- 37r: Inclined Reflecting Face
- 37w: Opening
- 40: Concentrating Solar Power Generation Module
- 50, 60: Concentrating Optical Member
- 51, 61: First Optical Member
- 51d, 61d, 62d: Inner Surface
- 51s, 61s, 62s: Outer Surface
- 52, 62: Second Optical Member
- 53: Anti-Reffection Film
- 54: Light-Transmitting Substrate
- 54s: Outer Surface
- 63: Glass Plate
- Cc: Center
- Lax: Optical Axis
- Ls, Lsa, Lsv: Sunlight
- Rr: Radius
- Ss: Side Length
- Wd: Working Distance

## Claims

1. A concentrating optical member that can be applied to a solar cell for generating power using sunlight concentrated onto a solar cell element and that can concentrate sunlight onto the solar cell element, comprising:
a first optical member having a first refractive index that is disposed on a side on which sunlight is incident and a second optical member having a second refractive index that is disposed on a side on which the solar cell element is located,
wherein the first refractive index and the second refractive index have different values.

2. The concentrating optical member according to claim 1,
wherein the first optical member is an imaging lens, and the second optical member is a non-imaging lens.

3. The concentrating optical member according to claim 1 or 2,
wherein the first optical member has an inner surface facing the solar cell element that is convex-shaped, and the second optical member is in close contact with the inner surface of the first optical member.

4. The concentrating optical member according to claim 1 or 2,
wherein the first optical member has an inner surface facing the solar cell element that is concave-shaped, and the second optical member is in close contact with the inner surface of the first optical member.

5. The concentrating optical member according to any one of claims 1 to 4,
wherein the second optical member is a Fresnel lens.

6. The concentrating optical member according to any one of claims 1 to 5,
wherein the second refractive index is larger than the first refractive index.

7. The concentrating optical member according to any one of claims 1 to 6, comprising a light-transmitting substrate that is in close contact with an outer surface of the first optical member on which sunlight is incident.

8. The concentrating optical member according to claim 7, comprising an anti-reffection film that is formed on an outer surface of the light-transmitting substrate.

9. The concentrating optical member according to any one of claims 1 to 6, comprising an anti-reflection film that is formed on an outer surface of the first optical member.

10. A concentrating solar power generation module that can concentrate sunlight onto a solar cell element using a concentrating optical member and that can generate power,
wherein the concentrating optical member is the concentrating optical member according to any one of claims 1 to 9.
